# EUROPEAN PATENT SPECIFICATION

(11) **EP 0 586 470 B1**
(45) Date of publication and mention of the grant of the patent: **18.03.1998**
(21) Application number: 92911025.2
(22) Date of filing: 05.06.1992
(51) Int. Cl.: G03F 7/30, G03F 7/20

(54) **PREPARATION OF PHOTOPOLYMERISED ELASTOMERIC PRINTING PLATES**
HERSTELLUNG PHOTOPOLYMERISIERTER ELASTOMER-DRUCKPLATTEN
PREPARATION DE PLANCHES A IMPRIMER ELASTOMERES PHOTOPOLYMERISEES

(30) Priority: 07.06.1991 GB 91122952
(43) Date of publication of application: 16.03.1994
(73) Proprietor: DANTEX GRAPHICS LTD., Bradford BD2 1EY (GB)
(72) Inventor: DANON, Richard 2 Wigton Chase, Leeds LS17 8SG (GB)
(74) Representative: Coleiro, Raymond
(86) International application number: GB9201019
(87) International publication number: WO9222014

(56) References cited:
- EP-A- 0 017 927
- DE-A- 3 143 106
- DE-U- 8 814 185
- FR-A- 2 021 570
- US-A- 3 942 259
- US-A- 3 958 586
- WORLD PATENTS INDEX Week 7814, Derwent Publications Ltd., London, GB; AN 78- 26893 & SU,A,542 167 ( UKR. PRINTING IND. )
- PATENT ABSTRACTS OF JAPAN vol. 11, no. 97 (P-560)(2544) 26 March 1987 & JP,A,61 248 052 ( KONISHIROKU PHOTO IND. )

## Description

This invention relates to the preparation of photopolymerised elastomeric printing plates and in particular to methods and apparatus for processing a pre-exposed photopolymerised elastomeric printing plate.

Automatic and continuous methods for processing printing plates are known. Machines for carrying out such methods provide a feed path within a housing along which a printing plate may be conveyed past stations where treatment processes are carried out. Such treatment processes may include washing, rinsing, drying and a light-treatment process where the plate is "post-exposed" in order to, for instance, modify the physical properties of the material of the plate. In existing processes, the drying step is always carried out before the post-exposure.

One particular problem with the production of photopolymerised elastomeric printing plates is that, after the treatment processes such as washing, rinsing, drying and post-exposing have been carried out, the printing plates so obtained normally have sticky surfaces, particularly on the relief, on the shoulders of the relief and in the image areas of the plate. Any polymer remaining in the non-image area would also have a sticky surface. The plate is accordingly difficult to handle and the sticky surfaces attract dust deposits. Furthermore, the sticky plates attract paper dust in paper-printing presses, giving rise to unsatisfactory print quality.

Another problem which arises when treating printing plates is the tendency of the polymer coating on pre-exposed plates to swell during the washing-out of the plates, due to take-up of the wash-out solvent. This in turn leads to poor quality printing, and it is therefore desirable to try to minimise the effects of polymer swelling on the final treated plate.

The impregnation of the photopolymer by the wash-out solution has always made it necessary for the final or post-exposure light treatment to be done after drying. The action of post-exposure is the final photopolymerisation or hardening of the image area. Therefore, effective drying needs to take place, thereby removing the impregnated solvent from the photopolymerised area, before post-exposure. Otherwise, the solvent impregnated image area would be hardened and fixed by post-exposure. Thus the swollen and dimensionally distorted areas would result in an uneven, fattened and generally non-acceptable printing quality.

In plate making, post-exposure has two functions. The first is to harden the polymer and the second is to remove stickiness (detack) from the surface of the polymer. The hardening process utilises light of wavelength 300-400nm and the detack process utilises light of wavelength 200-300nm.

EP-A-0017927 describes a method for processing a printing plate in which, after initial exposure and removal of the unhardened areas, the plate is dried and thereafter subjected to detack exposure with light having a wavelength not longer than 300nm, and post-exposure with light having a wavelength from 300 to 460nm. Depending on the composition of the photosensitive material, detack exposure may take place at the same time as the post-exposure. Examples are given in which the detack exposure precedes or follows on the post-exposure.

US-A-3942259 discloses a method for drying and curing a polymerisable layer of a photopolymer printing plate. A post-exposure treatment for curing the non-cured, non-washed portions of the polymerisable layer is carried out before drying the layer. The post-exposure may also be carried out during the drying process.

According to the present invention there is provided a method for processing a pre-exposed photopolymerised elastomeric printing plate, the method comprising feeding said plate within a housing along a path passing consecutively through the following process stations:
(a) a wash-out section where unexposed areas of the plate are removed (and which removal may be effected by brush action with downwardly facing bristles using a combination of both paddle and roller mounted assembly to effect a rotary and/or side to side and/or orbital movement) ;
(b) a rinse section in which the plate is rinsed with water;
(c) an excess water-removing section;
(d) a post-exposure section where the plate is simultaneously exposed to light having a wavelength of 300-400nm to effect post-exposure treatment and to light having a wavelength of 200-300nm to reduce the stickiness of the plate surface; and finally
(e) a drying section.

The new method of the invention is capable of yielding processed printing plates having a higher print quality than those yielded by conventional treatment processes. The new method combines, preferably, the use of plates having a polymer coating of a particular maximum swell rate, with the provision of a drying step after the plates have been subjected to post-exposure and detack, in contrast to conventional methods where drying takes place before post-exposure and detack. The application of this new method in the treatment of plates coated with polymers of maximum swell rate 10% or less leads to unexpected increases in the quality of the treated plates.

Generally all photopolymerisable polymers swell during wash-out. Accordingly, a polymer with a lower rate of swell, preferably 10% or less (see test result example 1 within this document) evidences considerable improvement in the finished plate quality as well as in the subsequent printing quality obtained from the plates treated using the new method of the invention.

The maximum swell rate is defined as the maximum percentage increase in weight of the polymer when subjected to immersion in the wash out solvent, at normal wash out temperatures, over a period of 24 hours. This should be 10% or less.

The present invention also provides apparatus for processing a pre-exposed photopolymerised elastomeric printing plate, the apparatus comprising a housing, means for feeding said plate within the housing along a path and, located adjacent said path, means for consecutively subjecting the plate to the following treatments
(a) wash out, where unexposed areas of the plate are removed;
(b) rinse with water;
(c) removal of excess water;
(d) post-exposure, the post exposure means including means for subjecting the plate to light having a wavelength of 300 - 400 nm to effect post-exposure treatment and means for simultaneously subjecting the plate to light having a wavelength of 200-300 nm to reduce the stickiness of the plate surface, and finally
(e) drying.

It is found that simultaneous post-exposure and "de-tack" treatment in a continuous processor results in printing plates having a quality at least as good as those from processors in which these stages are separated. However, the overall processing time is substantially reduced, perhaps by as much as 20 minutes, depending upon plate thickness, for the passage of a plate through the processor.

Apparatus of the present invention may be arranged to allow printing plates to pass through the various stages, within the housing, without being handled.

It is preferred that the apparatus of the invention is provided with a transporatation system for the conveyance of the printing plates within the housing. This transportation system may be a pin bar system using a chain drive mechanism or it may be a roller transport system driving plates forward or a transportation setter sheet system which may be magnetic for steel backed plates or sticky plastic for foil backed plates.

Preferably, the means for feeding the plate within the housing are capable of feeding the plate continuously and at an adjustable speed. Preferably, the apparatus includes control means for effecting the operation and switching-off of each treatment means so that treatment is only carried out when the plate is in the appropriate position and for a time sufficient to complete the treatment. Accordingly, the energy requirements of the apparatus are kept to a minimum.

Preferably, the apparatus is arranged for continuous through-put of printing plates in "nose-to-tail" manner as and when required.

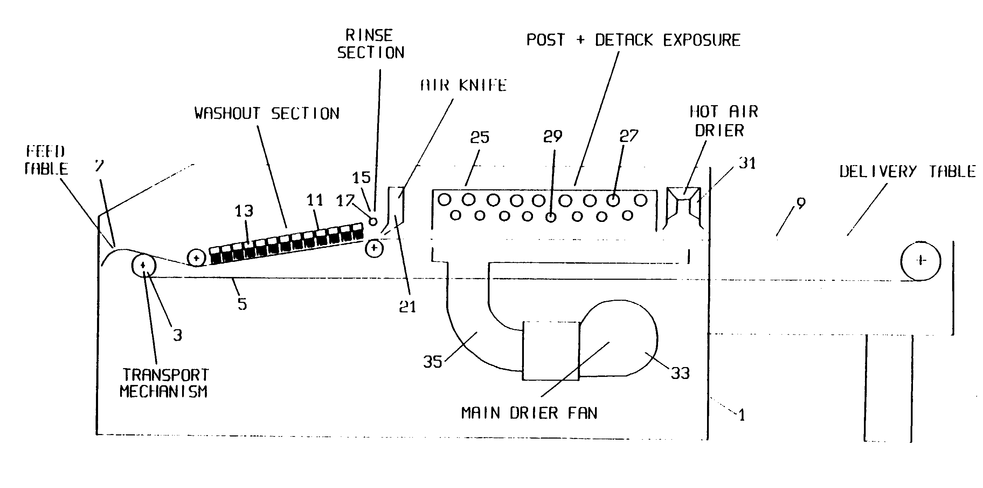

An embodiment of the present invention will now be described, by way of example only, and with reference to the accompanying drawing which shows diagrammatically apparatus according to the invention.

The apparatus as shown in the drawing includes the housing 1 within which there is provided a mechanism for feeding through the housing from left to right as shown in the drawing a pre-exposed photopolymer elastomeric printing plate. This transportation mechanism is indicated generally by various rollers 3 and conveyor belt 5. The printing plate is loaded into the housing onto feed table 7, and the plate is then transported automatically through the full length of the housing as it is subjected to various treatments. When the plate emerges from the housing, at the right-hand side thereof, it passes onto delivery table 9 where it comes to rest. The transportation mechanism may include a combination of endless drive chains, rollers, belts and setter sheet. The speed of transport of the plate through the housing is adjustable. Initially, the plate is placed upon the transportation system incorporated for transport through the housing.

The plate first enters wash out section 11 where unexposed areas of the plate are washed out using a combination of nylon/acrylic brushes 13 and heated wash-out solution. The brushes are both paddle and roller mounted to effect a rotary, side-to-side and orbital movement. The brush assemblies are provided with in-built spray bars to direct the wash-out solution to the areas of brush action on the plate.

The wash-out solution is water or a water and solvent mixture. The water is pre-heated by means of heated coil attachments to an internal in-feed pipe and is allowed to reach optimum required working temperature (which is variable by electronic control, located on the control panel) before it is fed through the brush head assembly on to the pre-exposed plate surface. This action is maintained throughout the operation cycle applied to the apparatus by predetermined settings adjusted electronically via the main control board.

In the event that solvent mixture is required to be added to the wash-out solution, this is fed from a holding tank via a pipe connection on to the internal in-feed pipe to the brush head assembly, the attachment point being located after the heating elements and just before the brush head assembly connection point.

The waste wash-out solution created by the brush washing action is allowed to pass into a filter (not shown) in order to filter all waste plate material from the wash-out solution, prior to this solution being recycled or expelled to drain.

Such an arrangement, which is a new total water loss system invented by Dantex, means that water is introduced and immediately heated only for as long as it is necessary to wash the plate. As there is no water holding tank, energy requirements are reduced and the equipment is particularly efficient in that there is a requirement to filter only the pre-calculated amount of water which is needed for application to the surface of the plate material. A simple catchment tray collects the water and passes it to the filter and thence to drain.

Subjecting the plate to wash out solution in this manner also means that the plate surface is only in contact with the wash out solution for the amount of time actually needed to wash out the plate. This helps to reduce swell in the plate's polymer coating during the wash out process, which in turn, in particular when combined with the use of a drying step after post-exposure and detack, as in the method of the invention, yields treated printing plates of a greatly improved quality.

The apparatus automatically monitors the amount of wash-out solution used within the processing cycle and replenishes this as required.

The plate next passes to rinse section 15. There it is rinsed with clean water via a spray-bar 17 extending the full width of the processor.

The plate then passes to section 19 which includes an air-blower system 21 of the "air knife" type to remove excess water from the surface of the plate. By avoiding the use of hard rollers at this stage, stress or dot squash is avoided.

The plate then passes into the light-finishing section 25. Within this section there are located two sets of fluorescent lightbulbs, the bulbs 27 of the upper set being arranged to produce light at a wavelength of 300-400 nm, and the bulbs 29 of the lower set being arranged to produce light with a wavelength of 200-300 nm. As indicated in the drawing, the bulbs in the upper set are offset from those in the lower set so that the light from both sets of bulbs can appropriately irradiate the plate.

While the plate is passing through the light-finishing section, it is subject simultaneously to light from the two sets of bulbs. The light from the upper set effects post-exposure of the printing plate material, and that from the lower set effects detack, that is to say, the stickiness of the plate is eliminated.

The plate then passes to the final stage within housing 1 which is the drying section and includes air blower 31 which directs a high-volume heated air-flow onto the plate to effect drying. The temperature of the air is pre-set, although adjustable, and is controlled automatically.

Also located within the housing is a main dryer fan 33 which provides, by means of conduit 35, drying to the underside of the plate in the area of the light-finishing section.

The "finished plate" passes from the light-finishing section out of the housing and comes to rest upon delivery-out table 9. In the case of the pin bar transportation system being used, the finished plate comes to rest upon the delivery out table 9 and the pin bar being automatically separated from the transportation chain belt driving mechanism.

An apparatus in accordance with the invention, such as that shown in the drawing, was used to process pre-exposed printing plates in accordance with the method of the invention, and the results compared with those of a conventional processing method, in which the drying step preceded post-exposure and detack. In examples 1 and 2, two different types of plate were tested: in example 1, a photopolymer plate wherein the swell rate is known to be below 10%; and in example 2, a plate wherein the swell rate is known to be 32%. The results of the tests were as follows:

| EXAMPLE 1: ³ | | | |
|---|---|---|---|
| Post Exposure and Detack | Strength of ¹ Dot (kg/mm²) | Stickiness (g/cm) | Reverse ² Depth (micron) |
| Before drying | 1.05 | 35 | 65 |
| After drying | 0.85 | 65 | 67 |

| | | | |
|---|---|---|---|
| REMARKS: ¹ = Isolated dot (diam 0.5mm) | | | |
| ² = Reverse width 0.2mm | | | |
| ³ = Polymer which is described in example 1 of Japanese Patent Application Kokai Publication No: 2-2/25262. | | | |

| EXAMPLE 2: ⁴ | | | |
|---|---|---|---|
| Post Exposure and Detack | Strength of ¹ Dot (kg/mm²) | Stickiness (g/cm) | Reverse ² Depth (micron) |
| Before drying | 1.3 | 12 | 35 |
| After drying | 1.25 | 13 | 60 |

| | | | |
|---|---|---|---|
| REMARKS: ⁴ Polymer : Torelief WF-95SSIIn Swelling Ratio 32% | | | |

The conclusions which can be drawn from these experimental results are as follows:
a) carrying out post-exposure and detack, before the drying step, as in the method of the invention, leads to:
   i) a **considerably stronger dot**, improved by up to 23.5%, resulting in a plate having greater anchorage of fine dot structures leading to long printing run results with material cost savings to printer.
   ii) **Less stickiness**, improved by up to 46%, resulting in a clean working plate offering the printer less stoppage during printing, thereby increasing printing efficiency. Less chemical usage is also proposed since the plate does not require to be washed down as regularly.
   iii) **Loss of depth of reverse**. A minor variation of 2 micron loss in the depth of reversal has been noted with the method of the invention (Example 1). Under physical printing conditions, this would not have any significant practical value.
b) these advantages are more marked when the method of the invention is used to treat plates whose polymer coatings have a swelling ratio of 10% or less, when immersed in wash out solvent for a period of 24 hours under wash out temperature.

## Claims

1. A method for processing a pre-exposed photopolymerised elastomeric printing plate, comprising feeding said plate within a housing along a path passing consecutively through the following process stations:
(a) a wash-out section where unexposed areas of the plate are removed;
(b) a rinse section in which the plate is rinsed with water;
(c) an excess water-removing section;
(d) a post-exposure section where the plate is simultaneously exposed to light having a wavelength of 300-400 nm to effect a hardening treatment and to light having a wavelength of 200-300 nm to reduce the stickiness of the plate surface; and finally
(e) a drying section.

2. A method according to Claim 1, wherein the printing plate is one having a photopolymer coating which has a maximum swell ratio of 10% or less when immersed in wash out solvent for a period of 24 hours under wash out temperature.

3. A method according to Claim 1 or Claim 2, wherein wash out solution used to wash out unexposed areas of the plate in the wash out section is allowed to flow over the plate in a continuous flow and to flow continuously from the wash out section after its contact with the plate, for filtration prior to its re-use in the method, or for filtration and then to drain.

4. Apparatus for processing a pre-exposed photopolymerised elastomeric printing plate, the apparatus comprising a housing, means for feeding said plate within the housing along a path and, located adjacent said path, means for consecutively subjecting the plate to the following treatments
(a) wash out, where unexposed areas of the plate are removed;
(b) rinse with water;
(c) removal of excess water;
(d) post-exposure, the post-exposure means including means for subjecting the plate to light having a wavelength of 300-400 nm to effect a hardening treatment and means for simultaneously subjecting the plate to light having a wavelength of 200-300 nm to reduce the stickiness of the plate surface; and finally
(e) drying.

5. Apparatus according to Claim 4, for use in processing a printing plate having a photopolymer coating which has a maximum swell ratio of 10% or less when immersed in wash out solvent for a period of 24 hours under wash out temperature.

6. Apparatus according to Claim 4 or Claim 5,
comprising means by which wash out solution used to wash out unexposed areas of the plate during the wash out treatment is allowed to flow over the plate in a continuous flow and to flow continuously from the housing after its contact with the plate, for filtration prior to its re-use in the apparatus, or for filtration prior to its passage to drain.

7. Apparatus according to any one of Claims 4-6, comprising means arranged to allow printing plates to pass through the various treatment stages, within the housing, without being handled.

8. Apparatus according to Claim 7, comprising a pin bar transport system or a roller drive system or a setter sheet transportation system, for conveying the printing plates within the housing.

9. Apparatus according to Claim 7 or Claim 8, wherein the means arranged to allow plates to pass through the treatment stages within the housing is capable of feeding the plates continuously and at an adjustable speed.

10. Apparatus according to any one of Claims 4-9, comprising control means for effecting the operation and switching-off of each treatment means so that treatment is only carried out when the plate is in the appropriate position and for a time sufficient to complete the treatment.

11. Apparatus according to any one of Claims 4-10, arranged for continuous through-put of printing plates in "nose-to-tail" manner as and when required.

## Patentansprüche

1. Verfahren zur Bearbeitung einer vorbelichteten, photopolymerisierten Elastomer-Druckplatte, umfassend das Befördern der Platte innerhalb eines Gehäuses entlang einer Wegstrecke, die nacheinander durch die folgenden Bearbeitungsstationen führt:
(a) einen Auswaschabschnitt, wo unbelichtete Flächen der Platte entfernt werden;
(b) einen Spülabschnitt, in dem die Platte mit Wasser gespült wird;
(c) einen Abschnitt zum Entfernen von überschüssigem Wasser;
(d) einen Nachbelichtungsabschnitt, wo die Platte gleichzeitig mit Licht einer Wellenlänge von 300-400 nm zur Durchführung einer Härtungsbehandlung und mit Licht einer Wellenlänge von 200-300 nm zur Verringerung der Klebrigkeit der Plattenoberfläche belichtet wird; und schließlich
(e) einen Trocknungsabschnitt.

2. Verfahren nach Anspruch 1, worin die Druckplatte eine mit einem Photopolymerüberzug ist, der ein maximales Aufquellverhältnis von 10% oder weniger aufweist, wenn er für eine Zeitspanne von 24 h bei Auswaschtemperatur in Auswasch-Lösungsmittel eingetaucht wird.

3. Verfahren nach Anspruch 1 oder 2, worin die zum Auswaschen unbelichteter Flächen der Platte im Auswaschabschnitt verwendete Auswaschlösung in einem kontinuierlichen Strom so über die Platte laufen gelassen wird, daß sie nach ihrem Kontakt mit der Platte aus dem Auswaschabschnitt kontinuierlich zur Filtration vor der Wiederverwendung im Verfahren oder zur Filtration und zum anschließenden Ablassen fließt.

4. Vorrichtung zur Bearbeitung einer vorbelichteten, photopolymerisierten Elastomer-Druckplatte, wobei die Vorrichtung umfaßt: ein Gehäuse, Mittel zur Beförderung der Platte innerhalb des Gehäuses entlang einer Wegstrecke, und zur Wegstrecke benachbart angeordnete Mittel, um die Platte nacheinander den folgenden Behandlungen zu unterziehen:
(a) Auswaschen, worin unbelichtete Flächen der Platte entfernt werden;
(b) Spülen mit Wasser;
(c) Entfernen von überschüssigem Wasser;
(d) Nachbelichtung, wobei die Mittel zur Nachbelichtung Mittel umfassen, um die Platte zur Durchführung einer Härtungsbehandlung Licht einer Wellenlänge von 300-400 nm auszusetzen, sowie Mittel, um die Platte zur Verroingerung der Klebrigkeit der Plattenoberfläche gleichzeitig Licht einer Wellenlänge von 200-300 nm auszusetzen; und schließlich
(e) Trocknen.

5. Vorrichtung nach Anspruch 4 zur Verwendung bei der Behandlung einer Druckplatte mit einem Photopolymerüberzug, der ein maximales Aufquellverhältnis von 10% oder weniger aufweist, wenn er für eine Zeitspanne von 24 h bei Auswaschtemperatur in Auswasch-Lösungsmittel eingetaucht wird.

6. Vorrichtung nach Anspruch 4 oder 5, umfassend Mittel, aufgrund derer die zum Auswaschen unbelichteter Flächen der Platte bei der Auswaschbehandlung verwendete Auswaschlösung in einem kontinuierlichen Strom über die Platte laufen gelassen wird und nach ihrem Kontakt mit der Platte aus dem Gehäuse kontinuierlich zur Filtration vor der Wiederverwendung in der Vorrichtung oder zur Filtration und dann zum Auslaß fließt.

7. Vorrichtung nach einem der Ansprüche 4 bis 6, umfassend Mittel, die so angeordnet sind, daß sie ermöglichen, daß Druckplatten ohne händisches Zutun durch die verschiedenen Behandlungsstufen innerhalb des Gehäuses gelangen.

8. Vorrichtung nach Anspruch 7, umfassend ein Nadelleisten-Transportsystem oder ein Walzenantriebssystem oder ein Aufsetzplatten-Transportsystem zur Beförderung der Druckplatten innerhalb des Gehäuses.

9. Vorrichtung nach Anspruch 7 oder 8, worin das Mittel, das so angeordnet ist, um zu ermöglichen, daß die Platten durch die Behandlungsstufen innerhalb des Gehäuses gelangen, die Platten kontinuierlich und mit einer regulierbaren Geschwindigkeit zuführen kann.

10. Vorrichtung nach einem der Ansprüche 4 bis 9, umfassend Steuermittel, um die Inbetriebnahme und das Abschalten jedes Behandlungsmittels durchzuführen, sodaß die Behandlung nur dann, wenn sich die Platte in einer entsprechenden Position befindet, und ausreichend lange, um die Behandlung abzuschließen, durchgeführt wird.

11. Vorrichtung nach einem der Ansprüche 4 bis 10, die zum kontinuierlichen Durchsatz von Druckplatten hintereinander ohne Abstand dazwischen, falls und wann immer erforderlich, vorgesehen ist.

## Revendications

1. Méthode de traitement d'une plaque d'impression élastomérique photopolymérisée pré-exposée, comprenant l'alimentation de ladite plaque dans un logement le long d'un chemin passant consécutivement à travers les stations du procédé suivantes :
(a) une section de lavage où les zones non exposées de la plaque sont éliminées;
(b) une section de rinçage dans laquelle la plaque est rincée avec de l'eau;
(c) une section d'élimination de l'eau en excès; excès;
(d) une section de post-exposition où la plaque est simultanément exposée à une lumière ayant une longueur d'onde de 300 à 400 nm pour effectuer un traitement de durcissement et à une lumière ayant une longueur d'onde de 200 à 300 nm pour réduire l'adhésivité et de la surface de la plaque; et finalement
(e) une section de séchage.

2. Méthode selon la revendication 1, dans laquelle la plaque d'impression est une plaque ayant un revêtement de photopolymère qui a un rapport de gonflement maximum de 10% ou moins lorsqu'immergé dans un solvant de lavage pendant une période de 24 heures à la température de lavage.

3. Méthode selon la revendication 1 ou la revendication 2, dans laquelle la solution de lavage utilisée pour laver les zones non exposées de la plaque dans la section de lavage est laissée à s'écouler sur la plaque en un écoulement continu et à s'écouler en continu de la section de lavage après son contact avec la plaque, pour filtration avant sa réutilisation dans la méthode, ou pour filtration et ensuite drainage.

4. Appareil pour le traitement d'une plaque d'impression élastomérique photopolymérisée pré-exposée, l'appareil comprenant un logement, un moyen pour alimenter ladite plaque dans le logement le long d'un chemin et, situés adjacents audit chemin, des moyens pour soumettre consécutivement la plaque aux traitements suivants
(a) lavage, où les zones non exposées de la plaque sont éliminées;
(b) rinçage avec de l'eau;
(c) élimination de l'eau en excès;
(d) post-exposition, les moyens de post exposition incluant des moyens pour soumettre la plaque à une lumière ayant une longueur d'onde de 300 à 400 nm pour effectuer un traitement de durcissement et des moyens pour soumettre simultanément la plaque à une lumière ayant une longueur de 200 à 300 nm pour réduire l'adhésivité de la plaque de surface; et finalement
(e) séchage.

5. Appareil selon la revendication 4, pour utilisation dans le traitement d'une plaque d'impression ayant un revêtement de photopolymère qui a un rapport de gonflement maximum de 10% ou moins lorsqu'immergé dans un solvant de lavage pendant une période de 24 heures à la température de lavage.

6. Appareil selon la revendication 4 ou la revendication 5, comprenant des moyens par lesquels la solution de lavage utilisée pour laver les zones non exposées de la plaque pendant le traitement de lavage est laissée à s'écouler sur la plaque en un écoulement continu et à s'écouler en continu du logement après son contact avec la plaque, pour filtration avant sa réutilisation dans l'appareil, ou pour filtration avant son passage à un drainage.

7. Appareil selon l'une quelconque des revendications 4 à 6 comprenant des moyens arrangés pour permettre aux plaques d'impression de passer à travers les divers étages de traitement, dans le logement, sans être manipulées.

8. Appareil selon la revendication 7, comprenant un système de transport à barreau tournant ou un système d'entraînement à rouleau ou un système de transport de feuille de support, pour convoyer les plaques d'impression dans le logement.

9. Appareil selon la revendication 7 ou la revendication 8, où les moyens arrangés pour permettre aux plaques de passer à travers les étages de traitement dans le logement sont capables d'alimenter les plaques en continu et à une vitesse ajustable.

10. Appareil selon l'une quelconque des revendications 4 à 9, comprenant des moyens de contrôle pour effectuer l'opération et l'arrêt de chaque moyen de traitement de sorte que le traitement est mis en oeuvre seulement lorsque la plaque est dans la position appropriée et pendant un temps suffisant pour compléter le traitement.

11. Appareil selon l'une quelconque des revendications 4 à 10, arrangé pour passer en continu des plaques d'impression d'une manière "nez-à-queue" comme et quand requis.
